# EUROPEAN PATENT APPLICATION

(11) **EP 4 671 780 A1**
(43) Date of publication of application: **31.12.2025**
(21) Application number: 25181552.8
(22) Date of filing: 09.06.2025
(51) Int. Cl.: G01R 31/3183, G06F 11/263, G01R 31/3185

(54) **TEST PATTERN GENERATING METHOD AND DEVICE**

(30) Priority: 26.06.2024 KR 20240083744; 20.08.2024 KR 20240111626
(71) Applicant: Samsung Electronics Co., Ltd., Suwon-si, Gyeonggi-do 16677 (KR)
(72) Inventor: KANG, Soyeon, 16677 Suwon-si (KR); SO, Kwangil, 16677 Suwon-si (KR)
(74) Representative: Marks & Clerk LLP

(57) **Abstract**

A test pattern generating method includes obtaining design data with respect to a circuit under test (CUT); generating, based on the design data, a first test pattern for detecting a transition delay (TD) fault and a pre-detected fault list (PDFL), wherein the PDFL comprises stuck-at (SA) faults, which respectively correspond to detectable TD faults that are included in a detectable TD fault list and are detectable through a simulation; and generating a second test pattern for detecting SA faults based on the design data and the PDFL.

## Description

### BACKGROUND

One or more example embodiments of the disclosure relate to a test pattern generating method and a test pattern generating device, and more particularly, to a test pattern generating method and a test pattern generating device capable of reducing a number of test patterns while maintaining a test coverage.

Modern digital circuits include millions of gates and flip-flops in many cases, making it almost impossible to manually generate test patterns with respect to the gates and the flip-flops. Therefore, it is required to develop an automatic test pattern generator (ATPG) tool capable of supporting various fault models and automatically generating effective test patterns at high speed. In particular, there is a need for technology capable of generating test patterns by reflecting various fault models and efficiently detecting faults through the test patterns.

### SUMMARY

One or more example embodiments of the disclosure provide a test pattern generating method and a test pattern generating device capable of reducing a number of required test patterns while maintaining a test coverage.

According to an aspect of an example embodiment of the disclosure, there is provided method, performed by at least one processor, of generating a test pattern, the method including: obtaining design data with respect to a circuit under test (CUT); generating, based on the design data, a first test pattern for detecting a transition delay (TD) fault and a pre-detected fault list (PDFL), wherein the PDFL comprises stuck-at (SA) faults, which respectively correspond to detectable TD faults that are included in a detectable TD fault list and are detectable through a simulation; and generating, based on the design data and the PDFL, a second test pattern for detecting SA faults, wherein the generating the second test pattern includes generating first SA fault candidates with respect to a modeled circuit of the CUT, based on the design data, generating second SA fault candidates, based on the PDFL and the first SA fault candidates, and generating the second test pattern based on the second SA fault candidates.

According to an embodiment, the method may further include testing the circuit under test by using the test pattern. The test pattern may include one or more test input patterns and one or more corresponding predicted output patterns. A test input pattern may be a combination of specific signals to be input to a digital circuit (e.g. the circuit under test) and may induce a specific operation of the digital circuit. In addition, a predicted output pattern may refer to an output expected from a normal (e.g. functioning) digital circuit having no fault when the corresponding test input pattern is input to the digital circuit. Accordingly, testing the circuit under test may comprise inputting one or more test input patterns into the circuit under test and comparing one or more outputs (e.g. one or more output patterns) from the circuit under test to one or more predicted output patterns corresponding to the one or more test input patterns. For instance, a fault may be identified in response to an output pattern generated by the circuit based on a test input pattern not matching the predicted output pattern corresponding to the test input pattern.

According to an aspect of an example embodiment of the disclosure, there is provided a test pattern generating device including at least one processor to implement: a transition delay (TD) automatic test pattern generator (ATPG) module configured to obtain design data with respect to a circuit under test (CUT) and generating, based on the design data, a first test pattern for detecting a transition delay (TD) fault and a pre-detected fault list (PDFL), wherein the PDFL comprises stuck-at (SA) faults, which respectively correspond to detectable TD faults that are included in a detectable TD fault list and are detectable through a simulation; and an SA ATPG module configured to generate, based on the design data and the PDFL, a second test pattern for detecting SA faults, wherein the SA ATPG module is configured to generate first SA fault candidates with respect to a modeled circuit of the CUT, based on the design data, generate second SA fault candidates, based on the PDFL and the first SA fault candidates, and generate the second test pattern based on the second SA fault candidates.

According to an aspect of an example embodiment of the disclosure, there is provided a system testing a circuit under test (CUT) by using a test pattern including: a test pattern generating device configured to obtain design data with respect to the CUT and generate based on the design data, a first test pattern for detecting a transition delay (TD) fault and a pre-detected fault list (PDFL), wherein the PDFL comprises stuck-at (SA) faults, which respectively correspond to detectable TD faults that are included in a detectable TD fault list and are detectable through a simulation, and an SA ATPG module configured to generate, based on the design data and the PDFL, a second test pattern for detecting SA faults, wherein the SA ATPG module is configured to generate first SA fault candidates with respect to a modeled circuit of the CUT, based on the design data, generate second SA fault candidates, based on the PDFL and the first SA fault candidates, and generate the second test pattern based on the second SA fault candidates.

According to an embodiment, the system further comprises a test device (200) configured to test the CUT by using the test pattern. The test pattern may comprise one or more test input patterns and one or more corresponding predicted output patterns. The test device may be configured to input the one or more test input patterns into the circuit under test and compare one or more outputs (e.g. one or more output patterns) from the circuit under test to the one or more predicted output patterns in order to test the circuit under test for faults. For instance, the system may be configured to identify a fault in response to an output pattern generated by the circuit based on a test input pattern not matching the predicted output pattern corresponding to the test input pattern.

At least some of the above and other features of the invention are set out in the claims.

### BRIEF DESCRIPTION OF DRAWINGS

Example embodiments will be more clearly understood from the following detailed description taken in conjunction with the accompanying drawings in which:
FIG. 1 is a block diagram illustrating a test system with respect to a circuit under test (CUT) according to an example embodiment of the disclosure;
FIG. 2 illustrates a data flowchart of a test pattern generating method performed by a test pattern generating device according to a comparative example.
FIG. 3 illustrates a data flowchart of a test pattern generating method performed by a test pattern generating device according to an example embodiment of the disclosure;
FIG. 4 is a diagram illustrating a test pattern generating method according to an example embodiment of the disclosure;
FIG. 5 is a flowchart illustrating a test pattern generating method according to an example embodiment of the disclosure;
FIG. 6 is a flowchart of operation S120 of a test pattern generating method in more detail, according to an example embodiment of the disclosure;
FIG. 7 is a diagram illustrating a method of generating a pre-detected fault list (PDFL), according to an example embodiment of the disclosure;
FIG. 8 is a flowchart of operation S 130 of a test pattern generating method in more detail, according to an example embodiment of the disclosure;
FIG. 9 illustrates a computing device for performing a test pattern generating method according to an example embodiment of the disclosure; and
FIG. 10 is a block diagram illustrating a test system according to an example embodiment of the disclosure.

### DETAILED DESCRIPTION

Hereinafter, one or more example embodiments of the disclosure are described with reference to the accompanying drawings.

Hereinafter, for convenience of description, terms such as "test pattern", "pattern", "test vector", and "vector" are used interchangeably. These terms may have the same meaning or different meanings according to the context of embodiment(s), and the meaning of each term will be understood according to the context of embodiment(s) to be described.

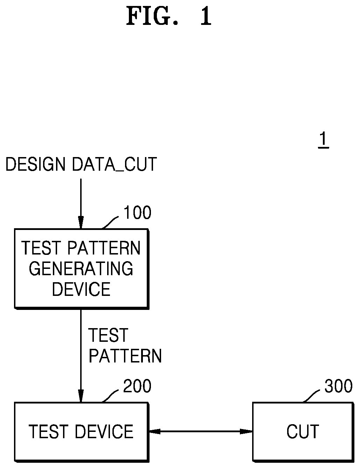

FIG. 1 is a block diagram illustrating a test system 1 with respect to a circuit under test (CUT) according to an example embodiment of the disclosure.

FIG. 1 is a block diagram illustrating the test system 1 according to an example embodiment.

Referring to FIG. 1, the test system 1 may include a test pattern generating device 100, a test device 200, and a CUT 300. According to an embodiment, the CUT 300 may include the test pattern generating device 100 and/or the test device 200, and thus, the test pattern generating device 100 and/or the test device 200 may be implemented as a built-in-self-test (BIST) circuit of the CUT 300.

The test pattern generating device 100 may receive design data DESIGN DATA_CUT with respect to the CUT 300 as an input value, and generate a test pattern based on the design data DESIGN DATA_CUT.

Here, the design data DESIGN DATA_CUT may include, for example but not limited to, netlist data, library data of a device in a circuit, and/or data of a parasitic component of a circuit wiring.

The netlist data may be data of connection information of a circuit, and may include information about each device (e.g., transistor, resistor, capacitor, etc.) in the circuit and information about a connection relationship between devices in the circuit. The library data of the device in the circuit may include information about a characteristic(s) and an operation(s) of the device used in the circuit, and may be referred to as a standard cell library. For instance, library data may describe one or more of: functional behavior, electrical properties (such as timing and power), and physical layout information for each device. The data of the parasitic component of the circuit wiring may include, for example but not limited to, information about a parasitic resistance, parasitic capacitance, and parasitic inductance of the circuit wiring.

In other words, the netlist data may define the operation of the circuit by defining a logical connectivity of the circuit, the library data of the device in the circuit may be used for circuit synthesis and timing analysis by defining a cell library, and the data of the parasitic component of the circuit wiring may be used for timing analysis.

According to an embodiment, the netlist data may be in a format of a Simulation Program with Integrated Circuit Emphasis (SPICE) netlist or a Verilog netlist, the library data of devices in the circuit may be in a format of a lib file, and the data of the parasitic component of the circuit wiring may be in a format of a spf file.

The test pattern generating device 100 may be referred to as an automatic test pattern generator (ATPG), and the test pattern generating device 100 may model the CUT 300 based on the design data DESIGN DATA_CUT, model a potential fault by using various fault models of the modeled CUT 300, and generate a test pattern by simulating the modeled CUT 300 based on the modeled potential fault. For example, the CUT 300 may be a digital circuit.

Here, the test pattern may include a test input pattern and a predicted output pattern. The test input pattern may be a combination of specific signals input to a digital circuit and may induce a specific operation of the digital circuit. In addition, the predicted output pattern may refer to an output expected from a normal digital circuit having no fault when the test input pattern is input to the digital circuit.

The test device 200 may receive the test pattern as an input value and perform a test operation for detecting a fault of the CUT 300 based on the test pattern.

For example, the CUT 300 may receive the test input pattern from the test device 200 as an input value and operate based on the test input pattern to provide a result of the test input pattern to the test device 200. When the result of the test input pattern of the CUT 300 matches the predicted output pattern, the test device 200 may determine that the CUT 300 does not have a fault corresponding to the test input pattern, and when the result of the test input pattern of the CUT 300 does not match the predicted output pattern, the test device 200 may determine that the CUT 300 has the fault corresponding to the test input pattern.

The test pattern generating device 100 may generate a pattern for detecting a static fault of the digital circuit based on the design data DESIGN DATA_CUT. Here, the static fault may mean a fault in which the digital circuit always outputs an incorrect value with respect to a specific input, regardless of an operating speed of the digital circuit. The static fault may be detected through a single operation.

That is, when a specific input vector is applied to the digital circuit, it may be determined that the static fault exists when an output of the digital circuit is different from an expected value.

For example, the static fault may include a stuck-at (SA) fault.

The SA fault may indicate a fault in which a specific signal within the digital circuit is always stuck at a certain value (e.g. 0 or 1).

Here, an SA fault in which a specific node of the digital circuit is always "logic 1" is referred to as an SA1 fault, and an SA fault in which a specific node of the digital circuit is always "logic 0" is referred to as an SA0 fault. That is, the SA fault may include the SA0 fault and the SA1 fault.

In addition, the test pattern generating device 100 may generate a pattern for detecting a dynamic fault of the digital circuit based on the design data DESIGN DATA_CUT. Here, the dynamic fault may mean a fault in which the digital circuit outputs an incorrect value with respect to a specific input at a specific operating speed of the digital circuit. The dynamic fault may be detected through a plurality of operations.

That is, when a specific input vector is applied to the digital circuit operating at a specific operating speed, it may be determined that the dynamic fault exists when the output of the digital circuit is different from the expected value.

For example, the dynamic fault may include a transition delay (TD) fault. Here, the TD fault may also be referred to as a transition fault.

The TD fault may indicate a fault in which a transition of a specific signal in the digital circuit is not completed within a predicted time (e.g. a predefined or required time).

Here, a fault in which a transition of a signal of a specific node of the digital circuit from "logic 1" to "logic 0" is not completed within a predicted time is referred to as a slow-to-fall TD (STF TD) fault, and a fault in which a transition of the signal of the specific node of the digital circuit from "logic 0" to "logic 1" is not completed within the predicted time is referred to as a slow-to-rise TD (STR TD) fault. That is, the TD fault may include the STF TD fault and the STR TD fault.

That is, the test pattern generated by the test pattern generating device 100 may include a TD test pattern and an SA test pattern according to a fault to be detected.

According to an embodiment, the test pattern generating device 100 may reduce a number of patterns required for a test by not generating the SA test pattern with respect to a node (or path) on which the TD test pattern is generated.

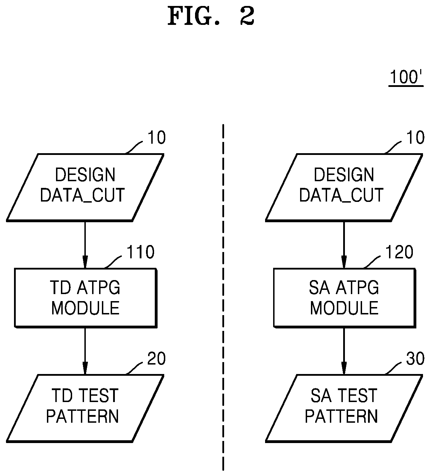

That is, according to an example embodiment of the disclosure, the test pattern generating device 100 may first generate a pattern (or referred to as the TD test pattern) capable of detecting the TD fault and generate a pattern (or referred to as the SA test pattern) capable of detecting the SA fault only with respect to a node (or path) capable of detecting the SA fault among nodes that do not correspond to the TD fault, thereby preventing duplicate generation of test patterns. Accordingly, the number of test patterns required for the test may be reduced, and a simulation cycle of an ATPG module performed to generate the test patterns by as many as the reduced test patterns may be reduced. This will be described in detail with reference to FIGS. 2 to 8.

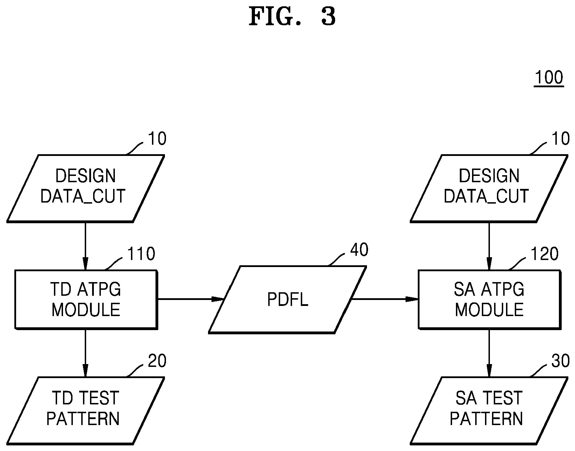

FIG. 2 illustrates a data flowchart of a test pattern generating method performed by a test pattern generating device 100' according to a comparative example. FIG. 3 illustrates a data flowchart of a test pattern generating method performed by the test pattern generating device 100 according to an example embodiment of the disclosure.

The test pattern generating device 100 according to an example embodiment of the disclosure may be implemented as software, hardware, or a combination of hardware and software. According to some embodiments, the test pattern generating device 100 may be implemented as a computing device or a computing system, and the test pattern generating method according to an example embodiment of the disclosure may be performed by the computing device or the computing system.

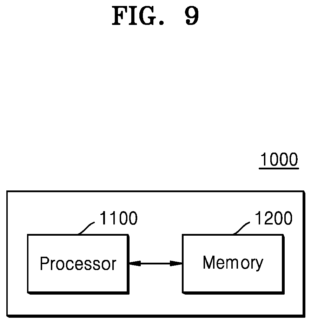

For example, the test pattern generating method according to an example embodiment of the disclosure may be performed by a computing system, as described later with reference to FIG. 9. For example, each of modules shown in FIGS. 2 and 3 may correspond to hardware, software, or a combination of hardware and software included in the computing system. The hardware may include at least one of a programmable component such as a central processing unit (CPU), a digital signal processor (DSP), a graphics processing unit (GPU), a reconfigurable component such as a field programmable gate array (FPGA), or a component that provides a predesigned function such as an intellectual property (IP) block. The software may include at least one of a series of instructions executable by the programmable component or a code convertible into a series of instructions by a compiler, and may be stored in a non-transitory storage medium.

Referring to FIGS. 2 and 3, each of the test pattern generating device 100' and the test pattern generating device 100 may include a TD ATPG module 110 and an SA ATPG module 120.

First, the test pattern generating method performed by the test pattern generating device 100' according to the comparative example is described with reference to FIG. 2.

The test pattern generating device 100' according to the comparative example independently generates a TD test pattern capable of detecting a TD fault and an SA test pattern capable of detecting an SA fault.

Referring to FIG. 2, the TD ATPG module 110 may receive design data DESIGN DATA_CUT 10 and generate a TD test pattern 20 based on the received design data 10. In addition, the SA ATPG module 120 may receive the design data 10 and generate an SA test pattern 30 based on the received design data 10. That is, each of the TD ATPG module 110 and the SA ATPG module 120 may independently generate a corresponding test pattern.

On the other hand, the test pattern generating device 100 according to an example embodiment of the disclosure may determine a detectable TD fault, generate a TD test pattern with respect to the detectable TD fault, and generate an SA test pattern based on a PDFL generated according to a determination result.

Referring to FIG. 3, the TD ATPG module 110 may receive the design data 10, determine the detectable TD fault based on the received design data 10, and generate a TD test pattern 20 with respect to the detectable TD fault. Here, the TD ATPG module 110 may generate a PDFL 40 based on the detectable TD fault and provide the PDFL 40 to the SA ATPG module 120.

In addition, the SA ATPG module 120 may receive the design data 10 and the PDFL 40 and generate the SA test pattern 30, based on the received design data 10 and the PDFL 40.

That is, the SA ATPG module 120 may generate the SA test pattern by referring to the detectable TD fault determined when the TD test pattern of the TD ATPG module 110 is generated. Here, SA faults corresponding to the generated SA test pattern may correspond to nodes excluding any nodes corresponding to the detectable TD fault in all SA fault candidates. For instance, SA fault detection may be performed only on nodes where no TD faults are detected. Accordingly, the number of patterns required for the SA fault test and the TD fault test may be reduced.

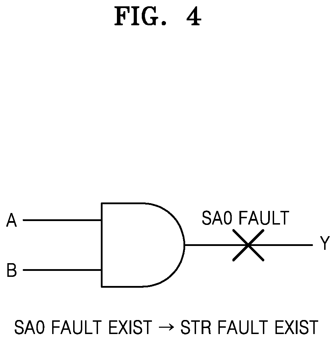

As described with reference to FIG. 4 below, according to an example embodiment, an SA fault for a specific node of a digital circuit may be detected through the TD test pattern. Accordingly, according to an example embodiment of the disclosure, even if a test pattern is not generated with respect to all of detectable SA faults, a test coverage based on the test pattern generated for some SA faults and the test pattern for a TD fault generated according to an example embodiment of the disclosure may be similar to a test coverage based on the test pattern with respect to all SA faults and the test pattern for the TD fault.

A case where an SA fault with respect to a specific node of a digital circuit may be detected through a TD test pattern is described in detail with reference to FIG. 4.

FIG. 4 is a diagram illustrating a test pattern generating method according to an example embodiment of the disclosure.

Referring to FIG. 4, it may be seen that it is assumed that an SA0 fault exists in an output pin Y of a logic AND circuit.

A test pattern (A, B) for detecting the SA0 fault in the output pin Y may be (1, 1). For example, when a value of Y is logic 0 when the test pattern (1, 1) is input, the SA0 fault may exist in the output pin Y.

In addition, when the SA0 fault is in the output pin Y, because it is impossible to change the output pin Y from logic 0 to logic 1, an STR TD fault may exist in the output pin Y. Similarly, when an SA1 fault is in the output pin Y, because it is impossible to change the output pin Y from logic 1 to logic 0, the STR TD fault may exist in the output pin Y.

A test pattern for detecting the STR TD fault in the output pin Y may be a test pattern set including two test patterns of (A, B). For example, a first test pattern set may include a first pattern (1 or 0, 0) and a second pattern (1, 1), and a second test pattern set may include the first pattern (0 or 1, 0), and the second pattern (1, 1). For example, when the value of Y is logic 0 due to the first pattern (1 or 0, 0) and the second pattern (1, 1) at a specific operating speed of the logical AND circuit, the STR TD fault may exist in the output pin Y.

Here, because both the first test pattern set and the second test pattern set include the second pattern (1, 1), the SA0 fault may also be detected with the test pattern for detecting the STR TD fault. Similarly, the SA1 fault may be detected with the test pattern for detecting the STF TD fault.

Therefore, an SA fault may be detected using the test pattern for detecting a TD fault.

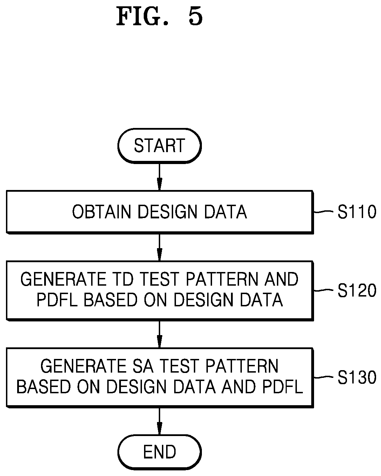

Hereinafter, examples of a test pattern generating method performed by the test pattern generating device 100 according to an example embodiment of the disclosure is described in more detail with reference to FIGS. 5 to 7.

FIG. 5 is a flowchart illustrating a test pattern generating method according to an example embodiment of the disclosure.

Referring to FIGS. 1 and 5, in operation S110, the test pattern generating device 100 may obtain the design data DESIGN DATA_CUT.

In addition, in operation S120, the test pattern generating device 100 may generate a TD test pattern and a PDFL, based on the design data DESIGN DATA_CUT.

In addition, in operation S130, the test pattern generating device 100 may generate an SA test pattern, based on the design data DESIGN DATA_CUT and the PDFL.

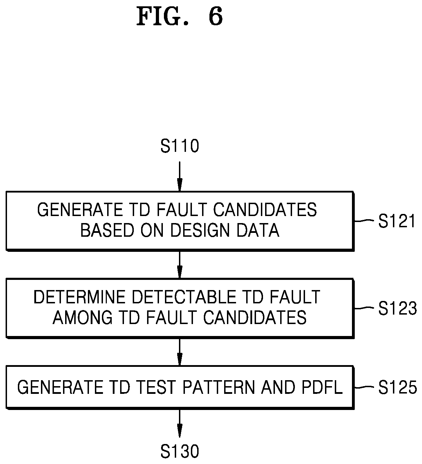

FIG. 6 is a flowchart of operation S120 of a test pattern generating method in more detail, according to an example embodiment of the disclosure.

Referring to FIG. 6, operation S120 may include operations S121, S123, and S125.

In operation S121, the test pattern generating device 100 (e.g., the TD ATPG module 110) may generate TD fault candidates with respect to a circuit modeled based on the design data DESIGN DATA_CUT.

Here, the TD fault candidates may be generated according to potential locations and/or types of TD faults that may occur in a digital circuit. For example, the TD fault candidate may correspond to a specific node (or a specific signal path) within the digital circuit where a TD fault may occur. In an embodiment, the TD fault candidates may correspond, one-to-one, to all nodes in the digital circuit. In an embodiment, the test pattern generating device 100 (e.g., the TD ATPG module 110) may generate the TD fault candidates by applying a TD fault model (e.g., an STR fault model or an STF fault model) to all nodes and paths identified in netlist data.

In an embodiment, the test pattern generating device 100 (e.g., the TD ATPG module 110) may classify the generated TD fault candidates into a not-detected (ND) state (or class). Here, ND may refer to a situation in which a test pattern of a corresponding TD fault candidate has not yet been generated.

In operation S123, the test pattern generating device 100 (e.g., the TD ATPG module 110) may determine one or more detectable TD faults among the TD fault candidates.

In an embodiment, the test pattern generating device 100 (e.g., the TD ATPG module 110) may determine the one or more detectable TD faults among the TD fault candidates based on whether the one or more detectable TD faults are detectable through a simulation based on a TD fault model.

Specifically, the test pattern generating device 100 (e.g., the TD ATPG module 110) may generate a plurality of test vectors based on the TD fault model with respect to each of the TD fault candidates. Thereafter, the test pattern generating device 100 (e.g., the TD ATPG module 110) may perform a simulation of applying each of the plurality of test vectors to the modeled circuit. Based on a simulation result, the test pattern generating device 100 (e.g., the TD ATPG module 110) may select at least one optimal test vector capable of detecting an actual TD fault. When the corresponding TD fault may not be actually detected through a simulation of applying the plurality of test vectors with respect to the corresponding TD fault candidate, the test pattern generating device 100 (e.g., the TD ATPG module 110) may determine the corresponding TD fault candidate as a TD fault that may not be detectable.

In an embodiment, the test pattern generating device 100 (e.g., the TD ATPG module 110) may classify the detectable TD faults into a detectable (DT) state (or class) and classify undetectable (UD) TD faults into a UD state (or class). Here, DT may refer to having generated a test pattern of the corresponding fault candidate, and UD may refer to being impossible to generate the test pattern of the corresponding fault candidate.

In operation S125, the test pattern generating device 100 (e.g., the TD ATPG module 110) may generate a TD test pattern and a PDFL.

In an embodiment, the test pattern generating device 100 (e.g., the TD ATPG module 110) may generate the TD test pattern by collecting test vectors selected respectively with respect to the detectable TD faults and predicted output patterns corresponding to the selected test vectors.

In addition, the test pattern generating device 100 (e.g., the TD ATPG module 110) may generate the PDFL based on the detectable TD faults.

Here, the PDFL may include SA faults corresponding to TD faults, that are detectable through a simulation using a TD test pattern and included in a detectable TD fault list. The PDFL may be used by the test pattern generating device 100 (e.g., the SA ATPG module 120) to generate a SA test pattern.

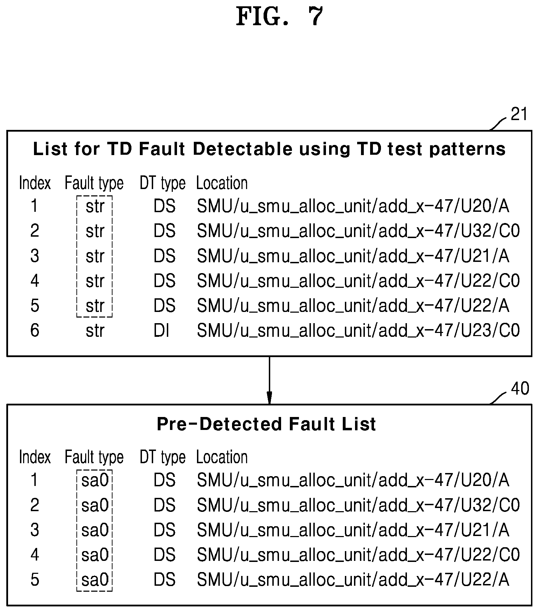

A method, performed by the test pattern generating device 100 (e.g., the TD ATPG module 110), of generating the PDFL based on detectable TD fault is described in detail with reference to FIG. 7.

FIG. 7 is a diagram illustrating a method of generating a PDFL, according to an example embodiment of the disclosure.

In addition to generating a TD test pattern based on detectable TD faults, the test pattern generating device 100 (e.g., the TD ATPG module 110) may generate a list (or detectable TD fault list) 21 including TD faults that are detectable using TD test patterns.

Information included in the list 21 for TD faults that are detectable using TD test patterns may include a fault identifier, a fault type, a fault location, a detection type, etc.

Here, the fault identifier may indicate an ID, an index or a number capable of uniquely identifying each of faults. In addition, the fault type may indicate whether a fault is an SA fault or a TD fault. In an embodiment, the fault type may indicate whether a fault is an SA0 fault or an SA1 fault, a STR TD fault, or an STF TD fault. In addition, the fault location may indicate information about a specific location and/or a node of a circuit where the fault has occurred.

In addition, the detection type may indicate how the fault was detected or a strength and/or characteristic of the detection.

For example, the detection type may be represented as detected by simulation (DS) or detected by implication (DI), depending on how the fault has been detected.

The DS detection type may mean detecting a fault by confirming whether the fault has been detected through a simulation of applying a test pattern generated by an ATPG module to a modeled circuit. That is, the DS may detect a fault in a corresponding node, based on a simulation of directly applying the test pattern.

The DI detection type may mean detecting a corresponding fault by using implicit logical relationship(s), and may detect a fault classified as the DI by identifying how a state of another signal or node is determined. That is, the DI means a case where the corresponding fault may be detected based on a specific logical condition, even when there is no direct test pattern applied. Examples of faults of the DI type may include a scan chain fault, a control logic fault, a clock gating fault, etc.

In addition, in some embodiments, for example, the detection type may be additionally represented by strong detection, weak detection, robust detection, or non-robust detection according to the strength of detection. For instance, the detection type may indicate a strength (or confidence) of the detection.

Referring to FIG. 7, it may be seen that the list 21 for TD faults detectable using TD test patterns is generated by the test pattern generating device 100 (e.g., the TD ATPG module 110).

Referring to FIG. 7, the list 21 for TD faults detectable using TD test patterns may include examples of an index corresponding to the fault identifier, the fault type indicating one of an STR corresponding to an STR TD fault, or an STF corresponding to a STF TD fault, a detection (DT) type indicating one of DS and DI according to how the corresponding fault has been detected, and a location corresponding to the fault location.

The test pattern generating device 100 (e.g., the TD ATPG module 110) may generate a PDFL 40 for SA faults by selecting only faults with DS detection type as the detection type among the TD faults in the list 21 for TD faults detectable using TD test patterns and generating a list for the selected SA faults. That is, the faults with DS as the detection type among the TD faults in the list 21 for TD faults detectable using TD test patterns may correspond to the SA faults included in the PDFL 40.

In addition, fault types of TD faults with DS as the detection type in the PDFL 40 may be reclassified into SA0 or SA1. As described with reference to FIG. 4, because SA0 faults may be detected with a test pattern for detecting STR TD faults and SA1 faults may be detected with a test pattern for detecting STF TD faults, the STR faults may be reclassified as the SA0 faults and the STF faults may be reclassified as the SA1 faults.

For example, referring to FIG. 7, when fault types of TD faults with DS as the detection type in the list 21 for TD faults detectable using TD test patterns are STR faults, fault types of the corresponding faults in the PDFL 40 may be reclassified as SA0.

Similarly, when fault types of TD faults with DS as the detection type in the list 21 for TD faults detectable using TD test patterns are STF faults, fault types of the corresponding faults in the PDFL 40 may be reclassified as SA1.

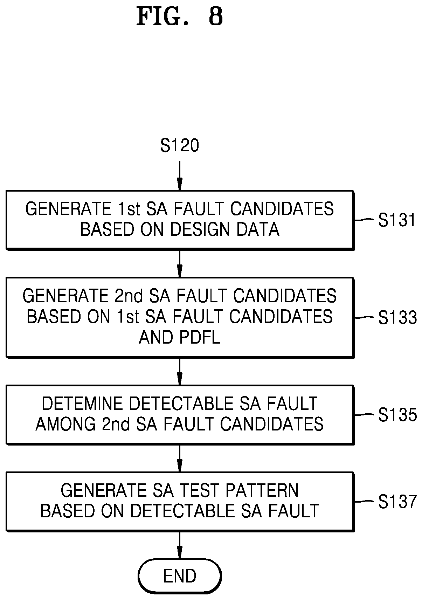

FIG. 8 is a flowchart of operation S130 of a test pattern generating method in more detail, according to an example embodiment of the disclosure.

Referring to FIG. 8, operation S130 may include operations S131, S133, S135, and S137.

In operation S131, the test pattern generating device 100 (e.g., the SA ATPG module 120) may generate first SA fault candidates for a circuit modeled based on the design data DESIGN DATA_CUT. Hereinafter, the first SA fault candidates may refer to SA fault candidates generated based on the design data DESIGN DATA_CUT.

Here, the first SA fault candidates may be generated according to potential locations and/or types of SA faults that may occur in a digital circuit. For example, the first SA fault candidate may correspond to a specific node (and/or a specific signal path) within the digital circuit where an SA fault may occur. In an embodiment, the first SA fault candidates may correspond, one-to-one, to all nodes in the digital circuit. In an embodiment, the test pattern generating device 100 (e.g., the SA ATPG module 120) may generate the first SA fault candidates by applying an SA fault model (e.g., an SA0 fault model or an SA1 fault model) to all nodes and/or paths identified in netlist data.

In an embodiment, the test pattern generating device 100 (e.g., the SA ATPG module 120) may classify the generated SA fault candidates into an ND state (or class). Here, ND may refer to a situation in which a test pattern of the corresponding fault candidate has not yet been generated.

In operation S133, the test pattern generating device 100 (e.g., the SA ATPG module 120) may generate second SA fault candidates based on the first SA fault candidates and a PDFL.

In an embodiment, the test pattern generating device 100 (e.g., the SA ATPG module 120) may generate the second SA fault candidates by removing SA faults included in both the first SA fault candidates and the PDFL from the first SA fault candidates. That is, the second SA fault candidates may be fault candidates in which SA faults included in the PDFL are removed from the first SA fault candidates.

In an embodiment, the test pattern generating device 100 may generate the second SA fault candidates by classifying the SA faults included in the PDFL into the detectable (DT) state (or class) from the first SA fault candidates. Here, DT may refer to a test pattern of a corresponding fault candidate having been generated. In addition, a test pattern is not actually generated with respect to the SA faults included in the PDFL, but the test pattern generating device 100 may remove the SA faults included in the PDFL from the first SA fault candidates by allowing the SA ATPG module 120 to recognize that the test pattern has been generated with respect to the SA faults included in the PDFL. That is, the second SA fault candidates may be generated based on SA fault candidates that correspond to the SA fault candidates included in the PDFL having been previously classified as the DT state in the first SA fault candidates.

In operation S135, the test pattern generating device 100 (e.g., the SA ATPG module 120) may determine detectable SA faults among the second SA fault candidates.

In an embodiment, the test pattern generating device 100 (e.g., the SA ATPG module 120) may determine the detectable SA faults among the second SA fault candidates based on whether the detectable SA faults are detectable through a simulation based on an SA fault model.

Specifically, the test pattern generating device 100 (e.g., the SA ATPG module 120) may generate a plurality of test vectors respectively with respect to the second SA fault candidates based on the SA fault model. Thereafter, the test pattern generating device 100 (e.g., the SA ATPG module 120) may perform a simulation of applying each of the plurality of test vectors to a modeled circuit. Based on a simulation result, the test pattern generating device 100 (e.g., the SA ATPG module 120) may select at least one test vector (e.g. at least one optimal test vector) capable of detecting an actual SA fault. When the corresponding SA fault may not be actually detected through a simulation of applying the plurality of test vectors with respect to the corresponding SA fault candidate, the test pattern generating device 100 may determine the corresponding SA fault candidate as an SA fault that may not be detectable.

In an embodiment, the test pattern generating device 100 (e.g., the SA ATPG module 120) may classify the detectable SA faults among the second SA fault candidates into the DT state (or class), and classify undetectable SA faults among the second SA fault candidates into the UD state (or class). Here, DT may refer to a test pattern of the corresponding fault candidate having been generated, and UD may refer to being impossible to generate the test pattern of the corresponding fault candidate.

In operation S137, the test pattern generating device 100 (e.g., the SA ATPG module 120) may generate an SA test pattern based on the detectable SA faults.

Specifically, the test pattern generating device 100 (e.g., the SA ATPG module 120) may generate the SA test pattern by collecting test vectors selected respectively with respect to the detectable SA faults among the second SA fault candidates and predicted output patterns corresponding to the selected test vectors.

That is, the TD test pattern generated by the test pattern generating device 100 (e.g., the TD ATPG module 110) may include test patterns capable of detecting the SA faults included in the PDFL. In addition, the SA test pattern generated by the test pattern generating device 100 (e.g., the SA ATPG module 120) may include test patterns with respect to the detectable SA faults among the second SA fault candidates and may not include test patterns with respect to the SA faults included in the PDFL.

According to an embodiment, the test pattern generating device 100 may reduce the number of patterns required for a test by not generating the SA test pattern with respect to a node (and/or path) on which the TD test pattern is generated.

That is, according to an example embodiment of the disclosure, the test pattern generating device 100 may first generate a pattern (or TD test pattern) capable of detecting the TD fault and generate the SA test pattern only with respect to a node (and/or path) capable of detecting the SA fault among nodes that do not correspond to the TD fault, thereby preventing duplicate generation of test patterns. Accordingly, the number of test patterns required for the test may be reduced, and a simulation cycle of an ATPG module performed to generate the test patterns by as many as the reduced test patterns may be reduced. By reducing the number of test patterns required for the test, the circuit under test may be tested more efficiently.

Accordingly, according to an example embodiment of the disclosure, even if a test pattern is not generated with respect to all of detectable SA faults, a test coverage based on the test pattern generated for some SA faults and the test pattern for a TD fault generated according to an example embodiment of the disclosure may be the same or similar to a test coverage based on the test pattern with respect to all SA faults and the test pattern for the TD fault.

FIG. 9 illustrates a computing device 1000 for performing a test pattern generating method according to an example embodiment of the disclosure.

The computing device 1000 of FIG. 9 may correspond to the test pattern generating device 100 according to one or more example embodiments described with reference to FIGS. 1 to 8. Here, the computing device 1000 may also be referred to as a computing system.

Referring to FIG. 9, the computing device 1000 may include a processor 1100 and a memory 1200. The one processor 1100 is illustrated in FIG. 9, but the disclosure is not limited thereto, and the computing device 1000 may include a plurality of processors.

The processor 1100 may include one or more cores (not shown) and a GPU (not shown) and/or a connection passage (e.g., a bus, etc.) for transmitting and receiving signals to and from other components.

The processor 1100 may perform operations of the test pattern generating method(s) described with reference to FIGS. 1 to 8 according to one or more example embodiments of the disclosure. For example, the processor 1100 may generate a test pattern for detecting a fault of a CUT based on the design data DESIGN DATA_CUT.

The processor 1100 may further include a random access memory (RAM) and a read-only memory (ROM) temporarily and/or permanently storing signals (or data) processed in the processor 1100. In addition, the processor 1100 may be implemented in a form of a system on chip (SoC) including at least one of a GPU, RAM, or ROM.

The memory 1200 may store programs (or one or more instructions) for processing and controlling the processor 1100. The memory 1200 may include a plurality of modules in which the test pattern generating method according to an example embodiment of the disclosure is implemented. For example, the memory 1200 may include the TD ATPG module 110 and the SA ATPG module 120 described with reference to FIG. 3.

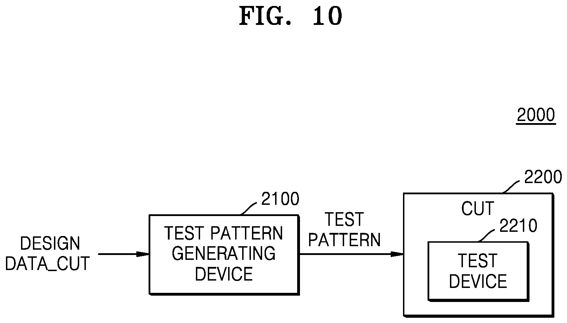

FIG. 10 is a block diagram illustrating a test system 2000 according to an example embodiment of the disclosure.

Referring to FIG. 10, various structures of the test system 2000 or a memory system according to an embodiment are described, but the scope of the disclosure is not limited thereto. Hereinafter, for convenience of description, detailed descriptions of the above-described components will be omitted.

Referring to FIG. 10, the test system 2000 may include a test pattern generating device 2100 and a CUT 2200. The CUT 2200 may include a test device 2210. That is, the test device 2210 may be implemented as a BIST circuit.

In an embodiment, the test device 2210 may be automated test equipment (ATE) testing the CUT 2200. The test device 2210 may receive a test pattern for testing the CUT 2200 from the test pattern generating device 2100. Here, the test pattern generating device 2100 may generate the test pattern based on the test pattern generating method(s) according to one or more example embodiments described with reference to FIGS. 1 to 9.

According to embodiments, the test device 2210 may apply the test pattern to the CUT 2200 to test the CUT 2200. For instance, the test device 2210 may be configured to input one or more test input patterns to the CUT 2200 and monitor one or more output patterns from the CUT 2220 based on the one or more input patterns. The one or more test input patterns may be defined by the test pattern and the one or more output patterns from the CUT 2220 may be compared to one or more predicted (or expected) output patterns from the test pattern. Where an output pattern does not match the predicted output pattern, a fault may be detected.

At least one of the components, elements, modules or units (collectively "components" in this paragraph) represented by a block in the drawings, may be embodied as various numbers of hardware, software and/or firmware structures that execute respective functions described above, according to an example embodiment. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above example embodiments may be implemented in algorithms that execute on one or more processors. Furthermore, the components represented by a block or processing steps may employ any number of related art techniques for electronics configuration, signal processing and/or control, data processing and the like.

While the disclosure has been particularly shown and described with reference to example embodiments thereof, it will be understood that various changes in form and details may be made therein without departing from the spirit and scope of the following claims.

## Claims

1. A method, performed by at least one processor, of generating a test pattern, the method comprising:
obtaining (S110) design data with respect to a circuit under test, CUT;
generating (S120), based on the design data, a first test pattern for detecting a transition delay, TD, fault and a pre-detected fault list, PDFL, wherein the PDFL comprises stuck-at, SA, faults, which respectively correspond to detectable TD faults that are included in a detectable TD fault list and are detectable through a simulation; and
generating (S130), based on the design data and the PDFL, a second test pattern for detecting SA faults,
wherein the generating (S130) the second test pattern comprises:
generating (S131) first SA fault candidates with respect to a modeled circuit of the CUT, based on the design data;
generating (S133) second SA fault candidates, based on the PDFL and the first SA fault candidates; and
generating (S137) the second test pattern based on the second SA fault candidates.

2. The method of claim 1, wherein each of the SA faults included in the PDFL is based on a fault type of each of the detectable TD faults included in the detectable TD fault list being classified as an SA fault.

3. The method of claim 2, wherein, based on the fault type of each of the detectable TD faults being a slow-to-rise, STR, fault, a fault type of the STR fault is reclassified as an SA0 fault, and
wherein, based on the fault type of each of the detectable TD faults being a slow-to-fall, STF, fault, a fault type of the STF fault is reclassified as an SA1 fault.

4. The method of any preceding claim, wherein the generating (S133) the second SA fault candidates includes removing SA faults included in both the first SA fault candidates and the PDFL from the first SA fault candidates.

5. The method of any preceding claim, wherein the generating (S133) the second SA fault candidates includes classifying the SA faults included in the PDFL into a detectable state in the first SA fault candidates.

6. The method of any preceding claim, wherein the second test pattern includes test patterns with respect to detectable SA faults among the second SA fault candidates and does not include test patterns with respect to the SA faults included in the PDFL.

7. The method of any preceding claim, wherein the first test pattern includes test patterns capable of detecting the SA faults included in the PDFL.

8. A test pattern generating device comprising at least one processor configured to implement:
a transition delay, TD, automatic test pattern generator, ATPG, module (110) configured to obtain design data with respect to a circuit under test, CUT, and generate, based on the design data, a first test pattern for detecting a TD fault and a pre-detected fault list, PDFL, wherein the PDFL comprises stuck-at, SA, faults, which respectively correspond to detectable TD faults that are included in a detectable TD fault list and are detectable through a simulation; and
a SA ATPG module (120) configured to, based on the design data and the PDFL, generate a second test pattern for detecting SA faults,
wherein the SA ATPG (120) module is configured to, in generating the second test pattern:
generate first SA fault candidates with respect to a modeled circuit of the CUT, based on the design data,
generate second SA fault candidates, based on the PDFL and the first SA fault candidates, and
generate the second test pattern based on the second SA fault candidates.

9. The test pattern generating device of claim 8, wherein each of the SA faults included in the PDFL is based on a fault type of each of the detectable TD faults of the detectable TD fault list being classified as an SA fault.

10. The test pattern generating device of claim 9, wherein, based on the fault type of each of the detectable TD faults being a slow-to-rise, STR, fault, a fault type of the STR fault is reclassified as an SA0 fault, and
based on the fault type of each of the detectable TD faults being a slow-to-fall, STF, fault, a fault type of the STF fault is reclassified as an SA1 fault.

11. The test pattern generating device of any of claims 8-10, wherein the SA ATPG module (120) is configured to generate the second SA fault candidates by removing SA faults included in both the first SA fault candidates and the PDFL from the first SA fault candidates.

12. The test pattern generating device of any of claims 8-11, wherein the SA ATPG module (120) is configured to generate the second SA fault candidates by classifying the SA faults included in the PDFL into a detectable state in the first SA fault candidates.

13. The test pattern generating device of any of claims 8-12, wherein the second test pattern includes test patterns with respect to detectable SA faults among the second SA fault candidates and does not include test patterns with respect to the SA faults included in the PDFL.

14. The test pattern generating device of any of claims 8-13, wherein the first test pattern includes test patterns capable of detecting the SA faults included in the PDFL.

15. A system for testing a circuit under test, CUT, by using a test pattern, the system comprising:
a test pattern generating device (100) according to any of claims 8-14; and
a test device (200) configured to test the CUT by using the test pattern.
